# FASCICULE DE BREVET EUROPEEN

(11) **EP 0 405 352 B1**
(45) Date de publication et mention de la délivrance du brevet: **23.02.1994**
(21) Numéro de dépôt: 90111863.8
(22) Date de dépôt: 22.06.1990
(51) Int. Cl.: H01L 39/12, H01L 39/24, C04B 35/00

(54) **Procédé de mise en forme d'une céramique supraconductrice**
Verfahren zur Herstellung eines supraleitfähigen keramischen Formkörpers
Process for producing a ceramic superconducting shaped article

(30) Priorité: 30.06.1989 FR 8908822
(43) Date de publication de la demande: 02.01.1991
(73) Titulaire: ALCATEL ALSTHOM COMPAGNIE GENERALE D'ELECTRICITE, 75382 Paris Cédex 08 (FR)
(72) Inventeur: Duperray, Gérard, F-91290 La Norville (FR); Ducatel, Françoise, F-78830 Bonnelles (FR)
(74) Mandataire: Weinmiller, Jürgen

(56) Documents cités:
- EP-A- 0 280 292
- EP-A- 0 288 236
- EP-A- 0 301 408
- FR-A- 2 615 506
- GB-A- 2 204 033
- GB-A- 2 207 128

## Description

La présente invention concerne un procédé de mise en forme d'une céramique supraconductrice, appartenant notamment à une famille de type Y-Ba-Cu-O.

De façon schématique on connaît déjà deux procédés de mise en forme de telles céramiques.

Selon un premier procédé on réalise un mélange de précurseurs sous forme de poudres, tels que Y₂O₃, CuO , et un oxyde ou un carbonate choisi parmi BaCO₃ , BaO et BaO₂ . Après compaction éventuelle, on effectue une synthèse de la phase supraconductrice par traitement thermique. Il s'agit d'une cuisson sous air ou sous oxygène vers 920°C après une montée lente en température. On broie le bloc poreux obtenu, on met en forme la poudre résultant du broyage, et on fritte. Un tel procédé est lent et fastidieux. Le broyage des précurseurs entraîne une pollution nocive. En effet il est nécessaire de travailler à sec ou en milieu solvant non aqueux pour la mise en forme de la poudre supraconductrice, car cette dernière est sensible à l'eau. On a un choix très restreint de solvants, de liants et d'adjuvants (défloculants, plastifiants, produits antimousse).

De plus, l'utilisation d'un liant entraîne une carbonatation de la phase supraconductrice pendant le frittage, par suite de la pyrolyse du liant. Cette carbonatation réduit la densité critique du courant de transport dans des proportions prohibitives. On est ainsi conduit à utiliser des taux de liant faibles, inférieurs à 2%, ce qui est insuffisant pour réaliser des pièces de formes pratiques (fils, tubes, etc...)

Selon un second procédé connu on part d'une solution de nitrates de Baryum, d'Yttrium et de Cuivre, que l'on précipite par l'acide oxalique. On obtient des particules submicroniques de l'ordre de 0,3 à 0,6 µm. Une suspension colloïdale de ces particules est atomisée pour donner des granulés de 10 à 20 µm qui sont comprimés à sec. Par un traitement vers 920°C on réalise la synthèse de la phase supraconductrice et le frittage. Pour un matériau présentant une orientation structurale bien définie, de section transversale de 0,83mm2 , la densité de courant critique J est de 730 A/cm² ;

Ce procédé ne mettant en oeuvre ni liant ni adjuvant (solvants - plastifiants...) n'a été appliqué qu'à la réalisation de pastilles de petites dimensions en vue de caractériser le matériau synthétisé. Cette technique ne paraît guère utilisable pour réaliser des pièces de forme, ceci pour 3 raisons :
- Taille des granulés (10 à 20 µm) : le diamètre "opérationnel" se situe autour de 100 µm pour constituer un véritable granulé de pressage.
- Réactivité des précurseurs oxalates vis-à-vis de l'eau conduisant plus à une suspension colloïdale limitée en extraits secs qu'à une barbotine qui, correctement défloculée, doit atteindre 70 à 80% d'extraits secs.
- Température élevée du traitement thermique (950 - 1000°C) sans doute imposée par la faible densité en cru due à l'emploi d'un granulé peu performant (fin et sans liant).

La présente invention a pour but de simplifier les procédés précités et d'en alléger le coût, tout en permettant d'obtenir des courants de transport critiques intéressants.

La présente invention a pour objet un procédé de mise en forme d'une céramique supraconductrice, notamment du type Y-Ba-Cu-O, caractérisé par le fait que l'on réalise un mélange comprenant (en poids) :
- 70% à 90% de précurseurs en proportions correspondant à la stoechiométrie de ladite céramique, ces précurseurs étant sous forme de poudres submicroniques avec des granulométries homogènes,
- 5% à 30% d'un liquide choisi parmi l'eau ou un liquide organique plastifiant,
- 0% à 2% d'un défloculant,
- un liant dans une proportion de 0% à 5% en milieu aqueux, et dans une proportion de 0% à 15% en milieu organique,
   et par le fait que l'on met en forme ce mélange par un procédé choisi parmi la pulvérisation, le coulage à plat, ou en moule de plâtre, l'atomisation, l'extrusion,
   et que l'on effectue un traitement thermique de synthèse-frittage sous pression partielle d'oxygène de la pièce crue obtenue, en faisant monter la température de 600°C à la température de frittage à environ 1 degré par minute, puis en maintenant, au niveau de la pièce, la température au-dessous de 900° pendant un palier de l'ordre d'une dizaine d'heures, puis en refroidissant ladite pièce lentement sous air entre 900° et 600° et sous oxygène pur et entre 600° et 300°.

Selon une première variante de mise en oeuvre ledit mélange se présente sous la forme d'une barbotine réalisée dans un broyeur à boulets avec :
- 70% à 85% en poids desdits précurseurs
- 10% à 20% d'eau
- 0,5% à 2% dudit défloculant, tel que le polyacrylate d'ammonium
- moins de 5% dudit liant choisi parmi le polyacrylamide, l'alcool polyvinylique, la polyvinypyrrolidone, le polyéthylène-glycol.
   On ajoute ensuite à ladite barbotine un agent antimousse dans une proportion d'environ 1‰, puis on effectue un dégazage.

Ladite barbotine peut être alors coulée dans un moule en plâtre poreux ; la pièce démoulée peut être de grande taille, présenter une forme complexe avec des parois de l'ordre de quelques millimètres.

Ladite barbotine peut être aussi déposée sur un substrat pour former une couche de l'ordre de quelques dixièmes de millimètres, cette couche étant réalisée par trempage, enduction ou pulvérisation.

Ladite barbotine peut être également atomisée dans un atomiseur à air chaud et être transformée en granulés de pressage, mis en forme par tout moyen de pressage, par exemple par compression isostatique. Les pièces obtenues peuvent être de toutes formes.

Selon une autre variante de mise en oeuvre, ledit mélange contient une concentration en extraits secs comprise entre 90% et 95%. Il forme alors une pâte que l'on malaxe à la température ambiante, que l'on agglomère sous vide par compression, et que l'on extrude sous pression pour former des fils de section quelconque, des baguettes (de 1cm² de section par exemple), des tubes (de 10cm² de section par exemple)

Selon une autre variante de mise en oeuvre, ledit mélange contient:
- 85% desdits précurseurs préalablement broyés une heure en présence de 0,8% de stéarate de glycol,
- 5% de liquide organique plastifiant choisi parmi le dibutylphtalate et les esters lourds
- 10% de liant tel que le polyéthylène basse densité.

Ce mélange constitue une pâte, extrudée ensuite sous pression à chaud pour former des fils, ensuite grillés sous air jusqu'à 600°, puis traités thermiquement.

La présente invention a également pour objet les produits supraconducteurs obtenus par le procédé précédent. Ces produits présentent une porosité résiduelle ouverte comprise entre 5% et 15%.

D'autres caractéristiques et avantages de la présente invention apparaîtront au cours de la description suivante d'exemples de réalisation donnés à titre illustratif mais nullement limitatif.

Dans tous les exemples mentionnés ci-dessous, les précurseurs Y₂ O₃, CuO, BaCO₃, sont sous forme de poudres ayant des diamètres inférieurs au micron et une surface BET comprise entre 2,5 et 10m²/g. Il faut remarquer que les poudres céramiques habituelles ont des diamètres compris entre 1 et 3 µm et des surfaces BET de l'ordre de 1m²/g.

Les granulométries des différents précurseurs sont voisines et leurs proportions correspondent à la stoechiométrie Y₁Ba₂Cu₃.

### EXEMPLE 1

On réalise une barbotine en broyant pendant une heure dans un broyeur à boulets :
- 70% d'un mélange des précurseurs précités
- 29% d'eau
- 1% de défloculant à base de polyacrylate d'ammonium, tel que celui vendu sous la marque "DOLAPIX CE" par la société ZSCHIMMER SCHWARZ.

Cette barbotine est ensuite dégazée sous vide après adjonction de 1 pour mille d'antimousse qui est un alcool gras vendu sous le marque "AFOMINE". Elle présente une viscosié de 1,4 centipoises.

Elle est alors coulée dans un moule en plâtre présentant une empreinte cylindrique ; l'excédent de liquide est vidé au bout d'une minute.
La partie essorée par succion est alors démoulée, séchée et traitée thermiquement de la manière suivante :
. Montée à 600°C à 3°C/ minute sous air
. Montée à 800°C à 0,5°C/ minute sous air
. Montée à 900°C à 0,33°C/ minute sous air
. Palier à 900°C de 16 heures
. Descente à 500°C à 0,5°C/ minute sous air
. Descente à 300°C à 0,3°C/ minute sous oxygène.

Le matériau ainsi obtenu présente un point de transition supraconductrice à 90K et un courant de transport critique de 500 A/cm² à 77K.

Le même procédé appliqué à de la poudre Y₁Ba₂ Cu₃O₇ ne conduit pas à un matériau supraconducteur.

### EXEMPLE II

On réalise une barbotine identique à celle décrite dans l'exemple I, sauf en ce qui concerne la proportion de ses constituants qui devient :
. 78% de mélange de précurseurs
. 20% d'eau
. 2% du défloculant précité
Après adjonction d'antimousse et dégazage sous vide, cette barbotine est atomisée dans un atomiseur à air chaud et conduit à des granulés de diamètres centrés sur 100 µm, utilisables pour réaliser des pièces massives par pressage uniaxial et isostatique : un tube de diamètre 13mm, d'épaisseur 1,5mm, et de longueur 70 mm, a été réalisé par pressage isostatique de granulés et traité thermiquement comme décrit dans l'exemple I.

Le matériau ainsi obtenu a présenté un courant de transport critique de 800A/cm² à 77K.

Le même procédé appliqué à de la poudre Y₁Ba₂Cu₃O₇ ne conduit pas à un matériau supraconducteur à 77K.

### EXEMPLE III

Il est pratiquement identique à l'exemple II pour la réalisation et les résultats. Mais, pour faciliter la réalisation de la barbotine, on ne met que 76% de précurseurs et on ajoute 2% d'un liant, tel qu'un polyéthylène glycol.

### EXEMPLE IV

On réalise une pâte en malaxant à la température ambiante :
. 90% de mélange des précurseurs de l'exemple I
. 4% d'un liant tel que le polyacrylamide
. 1% du défloculant précité.
. 5% d'eau
La pâte friable ainsi obtenue est agglomérée sous vide par compression dans un pot muni d'un piston ; puis elle est extrudée à travers une filière sous forme de fils de 0,5 mm et de 1mm de diamètre, sous une pression de 1000 bars.
Les fils sont séchés à 80° puis traités thermiquement comme dans l'exemple I ; leurs diamètres respectifs deviennent alors 0,4mm est 0,8mm.

Refroidis dans l'azote liquide à 77K ces fils deviennent supraconducteurs et présentent un courant de transport critique de 200A/cm²
Les fils équivalents réalisés à partir de Y₁Ba₂Cu₃O₇ en milieu éthanol, et en remplaçant le polyacrylamide par le polyvinylbutyral, dans le but d'éviter la dégradation par l'eau, présentent un courant critique de transport de 20A/cm² à 77K.

### EXEMPLE V

On réalise une pâte en malaxant à 90°C dans un malaxeur à cylindres :
. 85% de mélange de précurseurs préalablement broyés une heure en présence de 0,80% de stéarate de glycol
. 10% d'un liant tel que le polyéthylène basse densité
. 5% de liquide organique tel que le dibutylphtalate.

Cette pâte est extrudée à 90°C sous forme de fils de diamètres 0,5 et 1mm sous une pression de 1000 bars de manière analogue à la méthode décrite dans l'exemple IV, sauf en ce qui concerne la température.
Ces fils sont dans un premier temps grillés sous air, par élévation de la température à 1°C/minute jusqu'à 600°C, puis traités thermiquement comme dans l'exemple I : leurs dimamètres respectifs deviennent alors 0,4mm et 0,8mm.

Refroidis dans l'azote liquide à 77K, ces fils deviennent supraconducteurs et présentent un courant de transport critique de 100A/cm².

Les fils équivalents préparés avec du Y₁Ba₂Cu₃O₇ ne deviennent pas supraconducteurs à 77K.

Bien entendu , l'invention n'est pas limitée aux exemples décrits. Dans tous les cas, le procédé selon l'invention présente notamment les avantages suivants :
L'inertie chimique des précurseurs choisis par rapport à la phase supraconductrice présynthétisée élargit le domaine des procédés de mise en forme utilisables.

L'insensibilité au CO2 autorise l'usage de liants en quantité importante, nécessaire pour la réalisation de formes compliquées (films plastiques, fils fins, solénoïdes, pièces pour électro-technique).

La simplification par rapport au procédé classique permet un allégement du coût.

On obtient des courant de transport critiques intéressants : 800A/cm² sans orientation structurale.

## Revendications

1. Procédé de mise en forme d'une céramique supraconductrice, notamment du type Y-Ba-Cu-O, caractérisé par le fait que l'on réalise un mélange comprenant (en poids) :
- 70% à 90% de précurseurs en proportions correspondant à la stoechiométrie de ladite céramique, ces précurseurs étant sous forme de poudres submicroniques avec des granulométries homogènes,
- 5% à 30% d'un liquide choisi parmi l'eau ou un liquide organique plastifiant,
- 0% à 2% d'un défloculant,
- un liant dans une proportion de 0% à 5% en milieu aqueux, et dans une proportion de 0% à 15% en milieu organique,
et par le fait que l'on met en forme ce mélange par un procédé choisi parmi la pulvérisation, le coulage à plat ou en moule de plâtre, l'atomisation suivie d'un pressage, l'extrusion,
et que l'on effectue un traitement thermique de synthèse-frittage sous pression partielle d'oxygène de la pièce crue obtenue, en faisant monter la température de 600°C à la température de frittage à environ 1 degré par minute, et en maintenant, au niveau de la pièce, la température au-dessous de 900° pendant un palier de l'ordre d'une dizaine d'heures, puis en refroidissant ladite pièce lentement, sous air entre 900° et 600°et sous oxygène pur entre 600° et 300°.

2. Procédé selon la revendication 1, caractérisé par le fait que ledit mélange se présente sous la forme d'une barbotine réalisée dans un broyeur à boulets avec :
- 70% à 85% en poids desdits précurseurs
- 10% à 20% d'eau
- 0,5% à 2% dudit défloculant, tel que le polyacrylate d'ammonium,
- moins de 5% dudit liant choisi parmi le polyacrylamide, l'alcool polyvinylique, la polyvinylpyrrolidone, le polyéthylène glycol,
et par le fait que l'on ajoute ensuite à ladite barbotine un agent antimousse dans une proportion d'environ 1 pour mille , et que l'on effectue un dégazage sous vide.

3. Procédé selon la revendication 2, caractérisé par le fait qu'après dégazage ladite barbotine est coulée dans un moule en plâtre, et que la pièce crue démoulée est traitée thermiquement.

4. Procédé selon la revendication 2, caractérisé par le fait que ladite barbotine après dégazage est déposée sur un substrat pour former une couche de l'ordre de quelques dixièmes de millimètres, par trempage, enduction, ou pulvérisation, couche qui est ensuite traitée thermiquement

5. Procédé selon la revendication 2, caractérisé par le fait qu'après dégazage, ladite barbotine est atomisée dans un atomiseur à air chaud et est transformée en granulés utilisables pour réaliser des pièces massives par pressage, pièces qui sont traitées ensuite thermiquement.

6. Procédé selon la revendication 1, caractérisé par le fait que ledit mélange comporte entre 90% et 95% d'extraits secs, qu'il forme alors une pâte que l'on malaxe à la température ambiante, que l'on agglomère sous vide par compression, et que l'on extrude sous pression pour former des fils, des baguettes, ou des tubes, que l'on traite ensuite thermiquement.

7. Procédé selon la revendication 6, caractérisé par le fait que ledit mélange contient:
- 90% en poids desdits précurseurs,
- 5% d'eau,
- 1% dudit défloculant, tel que le polyacrylate d'ammonium
- 4% dudit liant choisi parmi le polyacrylamide, l'alcool polyvinylique, la polyvinylpyrrolidone, le polyéthylène-glycol.

8. Procédé selon la revendication 6, caractérisé par le fait que ledit mélange contient:
- 85% desdits précurseurs préalablement broyés une heure en présence de 0,8% de stéarate de glycol,
- 5% de liquide organique plastifiant choisi parmi le dibutylphtalate et les esters lourds,
- 10% de liant tel que le polyéthylène basse densité,
ledit mélange constituant un pâte, extrudée ensuite sous pression et à chaud pour former des fils, ensuite grillés sous air jusqu'à 600°C, puis traités thermiquement.

9. Produit obtenu à partir du procédé selon l'une des revendications précédentes, caractérisé par le fait qu'il présente une porosité résiduelle ouverte comprise entre 5% et 15%.

## Claims

1. A method of forming a superconducting ceramic, in particular of the Y-Ba-Cu-O type, the method being characterized by the fact that a mixture is made comprising the following (percentages by weight):
70% to 90% precursors of said ceramic in stoichiometric proportions, said precursors being in the form of submicron powders with uniform grain sizes;
5% to 30% of a liquid selected from water or a plasticizing organic liquid;
0% to 2% deflocculating agent; and
0% to 5% binder in an aqueous medium or 0% to 15% binder in an organic medium;
and by the fact that said mixture is formed by a method selected from: spraying; flat casting; casting in a plaster mold; atomizing followed by pressing; and extrusion;
and that synthesizing and sintering heat treatment is performed on the resulting raw part under a partial pressure of oxygen by raising the temperature from 600°C to the sintering temperature at about 1°C per minute, and by maintaining the temperature of the part at about 900°C for a pause of about 10 hours, then cooling the part slowly in air from 900°C to 600°C, and under pure oxygen from 600°C to 300°C.

2. A method according to claim 1, characterized by the fact that said mixture is in the form of a slip made in a ball mill using:
70% to 85% by weight of said precursors;
10% to 20% water;
0.5% to 2% of said deflocculating agent, such as ammonium polyacrylate;
at least 5% of said binder chosen from: polyacrylamide; polyvinyl alcohol; polyvinylpyrrolidone; and polyethylene glycol; and
by the fact that an antifoaming agent is subsequently added to said slip to a concentration of about one part per thousand, and degassing is performed under a vacuum.

3. A method according to claim 2, characterized by the fact that after degassing, said slip is cast in a plaster mold, and the raw unmolded part is subjected to heat treatment.

4. A method according to claim 2, characterized by the fact that after degassing said slip is deposited on a substrate in order to form a layer having a thickness of a few tenths of a millimeter, said slip being deposited by dipping, coating, or spraying, which layer is subsequently heat treated.

5. A method according to claim 2, characterized by the fact that after degassing, said slip is atomized in a hot air atomizer and is transformed into granules that are suitable for making solid parts by pressing, which parts are subsequently to heat treatment.

6. A method according to claim 1, characterized by the fact that said mixture includes between 90% and 95% dry extract, that it then forms a paste which is kneaded at ambient temperature and agglomerated under a vacuum by compression, and that it is extruded under pressure to form wires, rods, or tubes, which are then subjected to heat treatment.

7. A method according to claim 6, characterized by the fact that said mixture contains:
90% by weight of said precursors;
5% water;
1% of said deflocculating agent such as ammonium polyacrylate; and
4% of said binder selected from: polyacrylamide, polyvinyl alcohol; polyvinylpyrrolidone; and polyethylene glycol.

8. A method according to claim 6, characterized by the fact that said mixture contains:
85% of said precursors after prior grinding for one hour in the presence of 0.8% glycol stearate;
5% of a plasticizing organic liquid selected from dibutylphthalate and heavy esters; and
10% of binder such as low density polyethylene;
said mixture constituting a paste which is subsequently hot extruded under pressure to form wires, and then heated in air to 600°C, and then subjected to heat treatment.

9. A product obtained from the method of any preceding claim, characterized by the fact that it has residual open porosity lying in the range 5% to 15%.

## Patentansprüche

1. Verfahren zum Formen einer supraleitenden Keramik, insbesondere vom Typ Y-Ba-Cu-O, dadurch gekennzeichnet, daß man eine Mischung herstellt, die in Gewichtsteilen aufweist:
- 70% bis 90% Vorläufer in Anteilen, die der Stöchiometrie der betreffenden Keramik entsprechen, wobei die Vorläufer in Form von Pulvern im Submikronbereich mit homogener Korngrößenverteilung vorliegen,
- 5% bis 30% einer Flüssigkeit, wie wahlweise Wasser oder eine weichmachende organische Flüssigkeit,
- 0% bis 2% eines Entflockungsmittels,
- ein Bindemittel mit einem Anteil von 0% bis 5% im wässrigen Milieu, und mit einem Anteil von 0% bis 15% im organischen Milieu,
daß diese Mischung durch ein Verfahren in Form gebracht wird, das unter dem Pulverisieren, dem Flachgießen oder dem Gießen in Gipsform, der Atomisierung mit nachfolgendem Pressen, der Extrusion ausgewählt wird,
und daß eine Synthetisier-Sinter-Wärmebehandlung unter Sauerstoffpartialdruck des erhaltenen Roh-Formteils durchgeführt wird, indem die Temperatur von 600°C auf die Sintertemperatur mit ungefähr 1 Grad pro Minute gesteigert wird und indem in Höhe des Teils die Temperatur während etwa 10 Stunden unter 900°C gehalten wird, wonach das Teil langsam in Luft zwischen 900°C und 600°C und in reinem Sauerstoff zwischen 600°C und 300°C abgekühlt wird.

2. Verfahren nach Anspruch 1, dadurch gekennzeichnet, daß die Mischung in Form einer Aufschlämmung vorliegt, die in einer Kugelmühle hergestellt wird und in Gewichtsprozent aus:
- 70 bis 85% der Vorläufer,
- 10 bis 20% Wasser,
- 0,5 bis 2% des Entflockungsmittels wie etwa Ammoniumpolyacrylat, und
- weniger als 5% des Bindemittels besteht, das unter den Substanzen Polyacrylamid, Polyvinylalkohol, Polyvinylpyrrolidon, Polyäthylenglykol gewählt ist,
und daß anschließend der Aufschlämmung ein Entschäumungsmittel mit einem Anteil von ungefähr 1 pro Mille hinzugefügt wird und eine Entgasung unter Vakuum durchgeführt wird.

3. Verfahren nach Anspruch 2, dadurch gekennzeichnet, daß die Aufschlämmung nach der Entgasung in eine Gipsform gegossen wird und daß das von der Form befreite Rohteil thermisch behandelt wird.

4. Verfahren nach Anspruch 2, dadurch gekennzeichnet, daß die Aufschlämmung nach der Entgasung auf ein Substrat aufgebracht wird, um eine Schicht von einigen Zehntel Millimetern Dicke durch Eintauchen, Auftragen oder Pulverisieren hergestellt wird, woraufhin die Schicht thermisch behandelt wird.

5. Verfahren nach Anspruch 2, dadurch gekennzeichnet, daß die Aufschlämmung nach dem Entgasen in einem Zerstäuber unter Warmluft zerstäubt und in Körner umgeformt wird, die zur Herstellung massiver Teile durch Pressen verwendbar sind, woraufhin die Teile anschließend thermisch behandelt werden.

6. Verfahren nach Anspruch 1, dadurch gekennzeichnet, daß die Mischung zwischen 90 und 95% trockene Auszüge enthält und dann eine teigige Masse bildet, die bei Umgebungstemperatur durch Kneten gemischt wird, daß die Masse unter Vakuum durch Verdichten agglomeriert wird und dann unter Druck zur Herstellung von Drähten, Stäben oder Rohren extrudiert wird und anschließend thermisch behandelt wird.

7. Verfahren nach Anspruch 6, dadurch gekennzeichnet, daß die Mischung in Gewichtsprozent enthält:
- 90% der Vorläufer,
- 5% Wasser,
- 1% des Entflockungsmittels, wie etwa Ammoniumpolyacrylat, und
- 4% des Bindemittels, das unter den Substanzen Polyacrylamid, Polyvinylalkohol, Polyvinylpyrrolidon, Polyäthylenglykol ausgewählt wird.

8. Verfahren nach Anspruch 6, dadurch gekennzeichnet, daß die Mischung enthält:
- 85% der Vorläufer, die vorher während einer Stunde in Gegenwart von 0,8% Glykolstearat gemahlen worden sind,
- 5% weichmachende organische Flüssigkeit, die unter den schwerflüchtigen Estern und Dibutylphthalat ausgewählt ist,
- 10% des Bindemittels, wie etwa Polyäthylen geringer Dichte, wobei die Mischung eine teigige Masse bildet, die anschließend unter Druck und heiß zur Bildung von Drähten extrudiert wird, worauf die Drähte in Luft bis auf annähernd 600°C geröstet und schließlich thermisch behandelt werden.

9. Produkt, das mit dem Verfahren gemäß einem der vorhergehenden Ansprüche gewonnen wurde, dadurch gekennzeichnet, daß es eine offene Restporosität zwischen 5% und 15% besitzt.
